# EUROPEAN PATENT SPECIFICATION

(11) **EP 0 588 092 B1**
(45) Date of publication and mention of the grant of the patent: **27.03.1996**
(21) Application number: 93113272.4
(22) Date of filing: 19.08.1993
(51) Int. Cl.: G03F 7/038, G03F 7/004, G03F 7/029

(54) **Negtive photoresist composition**
Negativ arbeitende Photoresistzusammensetzung
Composition photorésistante négative

(30) Priority: 20.08.1992 JP 221373/92
(43) Date of publication of application: 23.03.1994
(73) Proprietor: SUMITOMO CHEMICAL COMPANY, LIMITED, Osaka (JP)
(72) Inventor: Ueda, Yuji, Izumi-shi (JP); Takeyama, Naoki, Settsu-shi (JP); Ueki, Hiromi, Mishima-gun, Osaka (JP); Kusumoto, Takehiro, Takarazuka-shi (JP); Nakano, Yuko, Ibaraki-shi (JP)
(74) Representative: VOSSIUS & PARTNER

(56) References cited:
- EP-A- 0 164 248
- EP-A- 0 407 086
- US-A- 4 189 323
- Section Ch, Week 9248, Derwent Publications Ltd., London, GB; Class A89, AN 92-393356 & JP-A-04 291 261
- PATENT ABSTRACTS OF JAPAN vol. 016, no. 407 (P-1411) 27 August 1992 & JP-A-4 136 858

## Description

The present invention relates to a resist composition usable as a pattern-forming material in the production of semiconductors, and more particularly to a negative photoresist composition suitable for use in lithographies using far ultraviolet rays including excimer laser.

Recently, with a rise in the integration level of integrated circuits, formation of patterns of sub-micron order is required. Particularly, excimer laser lithography using excimer laser as a light source makes it possible to produce 64 and 256 MDRAMs. As a result of such an alteration of light source, the following properties are demanded of the today's resists in addition to the hitherto required properties such as heat resistance , or film thickness retention:
(1) a high sensitivity to the light sources mentioned above,
(2) a high resolution,
(3) a good profile, and
(4) a small standing wave.

Prior negative photoresist compositions cannot be said to be satisfactory from the above-mentioned viewpoints. For example, JP-A-1-293339 (1989) discloses a photoresist composition comprising a polymer containing a group represented by the following formula (I): 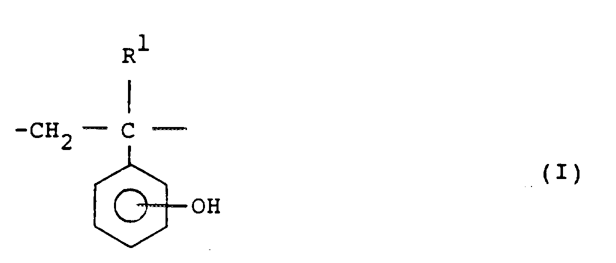 wherein R¹ represents hydrogen atom or alkyl group having 1 to 5 carbon atoms, a crosslinking agent containing a group represented by the following formula: 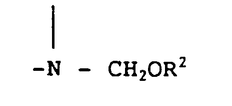 wherein R represents a hydrogen atom or an alkyl group having 1 to 5 carbon atoms, and a photo-induced acid precursor containing a sulfonic acid ester group. If a pattern is formed from this composition, however,the profile is not good or the film thickness retention is low and a pattern of 0.4 µm or less cannot sufficiently be resolved.
Thus, it is the object of the present invention to solve the problems mentioned above and to provide a negative photoresist composition suitable for use in far ultraviolet lithographies and particularly KrF excimer laser lithography, excellent in properties such as resolution, sensitivity, heat resistance, profile or film thickness retention, and small in standing wave. This object has been achieved by a negative photoresist composition comprising an alkali-soluble resin containing a mixture of Resin A obtainable through a copolymerization of p-hydroxystyrene and styrene and Resin B obtainable through a hydrogenation of poly(p-hydroxystyrene), a crosslinking agent and a photo-induced acid precursor.

Resin A can easily be produced by a radical copolymerization or ion copolymerization of p-hydroxystyrene and styrene. The molar ratio of p-hydroxystyrene and styrene in the copolymer is usually from about 50/50 to about 95/5, and preferably from about 70/30 to about 85/15. If the proportion of p-hydroxystyrene is smaller than the above, the copolymer is difficult to dissolve in solvent at the time of preparing a resist solution or difficult to dissolve in aqueous alkali solution at the time of development. On the other hand, if the proportion of p-hydroxystyrene is greater than the above, the copolymer is too readily soluble in aqueous alkali solution, so that no fine pattern can be formed therefrom. Resin A has a weight average molecular weight of from about 1,000 to about 5,000, preferably from about 2,500 to about 4,000.

Poly(p-hydroxystyrene) and Resin B are readily available commercially. Resin B can easily be produced by hydrogenating poly(p-hydroxystyrene) in the usual manner.

The mixing ratio of Resin A and Resin B is usually from about 99/1 to about 10/90, preferably from about 70/30 to about 40/60.

Examples of the crosslinking agent usable in the present invention include compounds represented by the following formula (II): 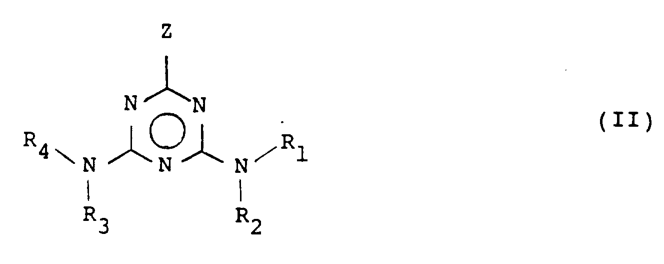 wherein Z represents -NRR' or a phenyl group, R, R' and R₁ to R₄ independently of one another each represents a hydrogen atom, -CH₂OH or -CH₂ORₐ in which Rₐ represents an alkyl group, or compounds of the following formulas: 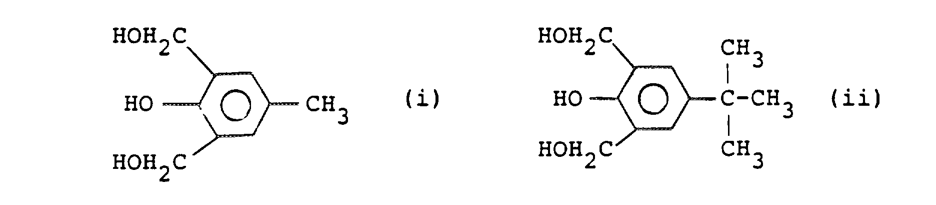 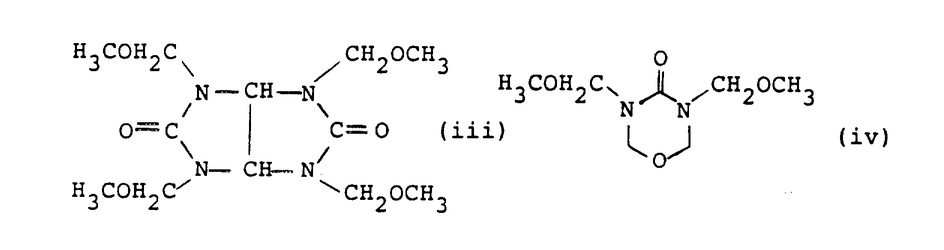 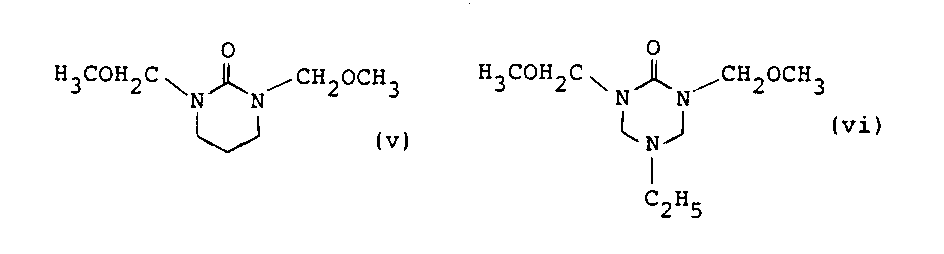 and the like. Among these compounds, the compounds represented by formula (II) are preferable. As the alkyl group represented by Rₐ, straight chain and branched chain alkyl groups having 1 to 7 carbon atoms, particularly methyl, ethyl, n-propyl and n-butyl are preferable, and methyl and ethyl are more preferable. Among the compounds represented by formula (II), melamine and benzoguanamine are readily available commercially. Their methylol derivatives can be obtained by a condensation of melamine or benzoguanamine with formalin, and their methylol ether derivatives can be obtained by reacting their methylol derivatives with various alcohols according to known methods. Among the compounds presented above, (i) and (ii) can be produced by reacting the corresponding phenol compound with formaldehyde under a basic condition, and (iii) to (vi) are known compounds mentioned in JP-A-1-293339 (1989) . Examples of the compound represented by the formula (II) include the following:

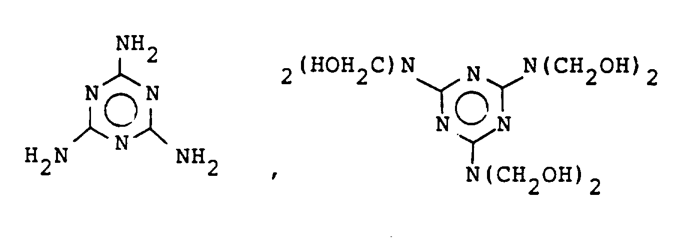

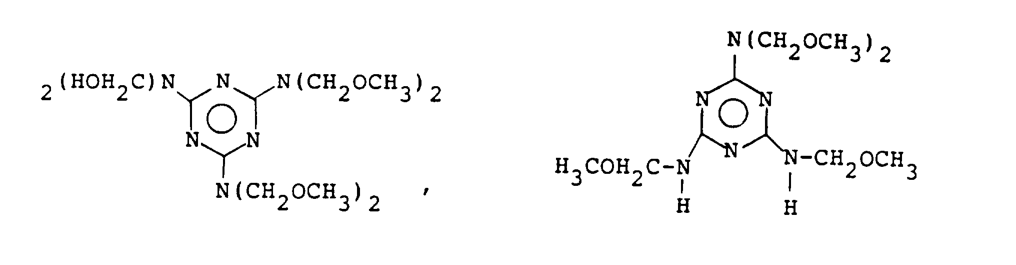

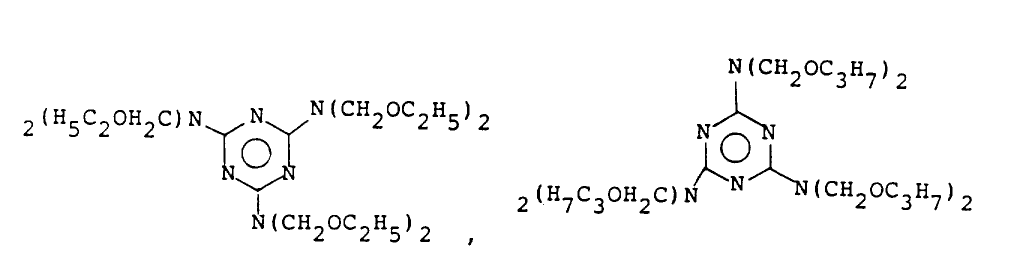

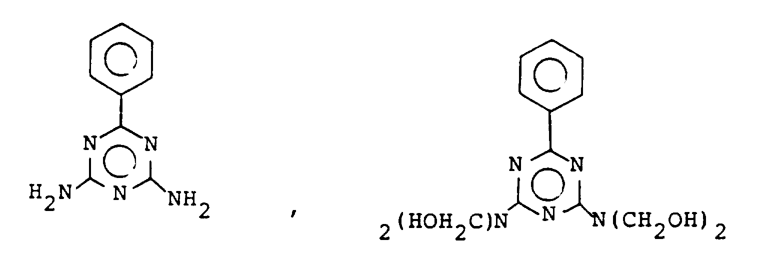

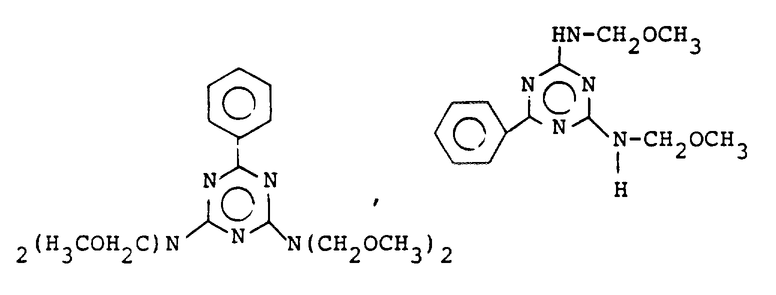

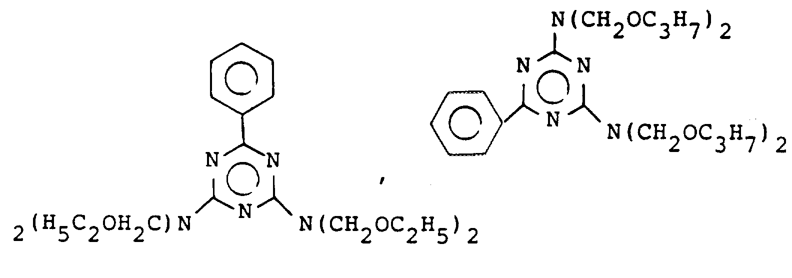

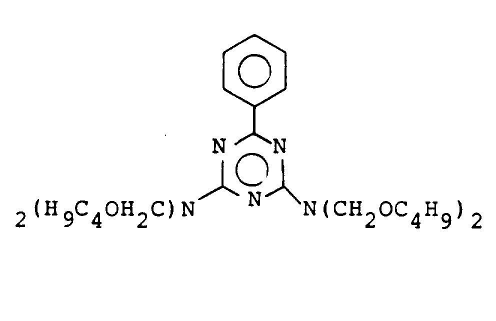

Examples of the photo-induced acid precursor include compounds represented by the following formula (III): 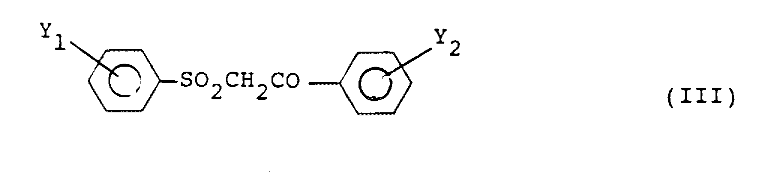 wherein Y₁ and Y₂ independently of one another each represents a hydrogen atom, alkyl group, alkenyl group or alkoxy group; compounds represented by the following formula (IV): 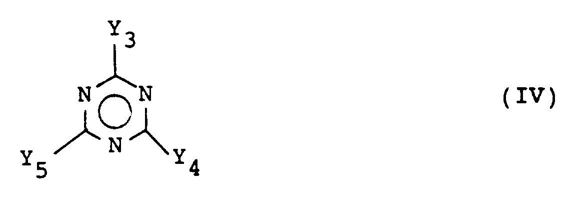 wherein Y₃, Y₄ and Y₅ each represents optionally substituted alkyl, alkenyl, aryl, aralkyl, piperidino, -N(Y₆)(Y₇), -OY₈ or -SY₉ in which Y₆ to Y₉ independently of one another each represents a hydrogen atom or an optionally substituted alkyl or aryl group, provided that at least one of Y₃, Y₄ and Y₅ represents a mono-, di- or tri-halogen-substituted alkyl group; disulfone compounds represented by the following formula (IX):

Y₁₈-SO₂-SO₂-Y₁₉ (IX)

wherein Y₁₈ and Y₁₉ each represents an optionally substituted aryl, aralkyl, alkyl, cycloalkyl or heterocyclic group, provided that at least one of Y₁₈ and Y₁₉ is an optionally substituted aryl, aralkyl or heterocyclic group; compounds represented by the following formula (X):

Y₂₀-SO₂-SO₂-Y₂₁-SO₂-SO₂-Y₂₂ (X)

wherein Y₂₀ and Y₂₂ independently of one another each represents an optionally substituted aryl, aralkyl, alkyl, cycloalkyl or heterocyclic group and Y₂₁ represents an optionally substituted aryl group; trifluoromethanesulfonic acid esters; and the like.

In the formula (III), examples of the alkyl and alkoxy groups represented by Y₁ and Y₂ include straight chain and branched chain alkyl and alkoxy groups having 1 to 5 carbon atoms, among which methyl, methoxy, ethyl and ethoxy are preferable. Preferable examples of the alkenyl group represented by Y₁ and Y₂ include alkenyl groups having 2 to 6 carbon atoms. Examples of the compound represented by the formula (III) include the following:

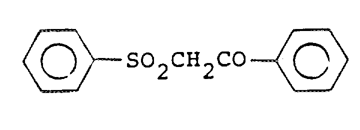

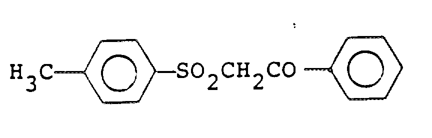

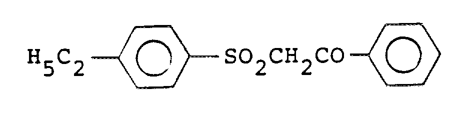

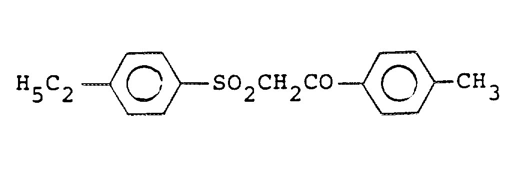

The compounds represented by the formula (III) can be produced by, for example, reacting sodium sulfinate or its derivative with an acetophenone bromide compound.

In the formula (IV), examples of the alkyl group represented by Y₃ to Y₅ include straight chain and branched chain alkyl groups having 1 to 7 carbon atoms, among which methyl, ethyl, n-propyl, i-propyl, n-butyl, and i-butyl are preferable. As a preferable substituent present on the alkyl group, for example, halogen atoms can be referred to. Preferable examples of the alkenyl group represented by Y₃ to Y₅ include straight chain and branched chain alkenyl groups having 2 to 7 carbon atoms. As a preferable substituent present on the alkenyl group, for example, aryl groups such as phenyl and naphthyl and heterocyclic groups such as benzoxazolyl and benzothiazolyl can be referred to. These aryl groups and heterocyclic groups may additionally be substituted by halogen atoms,alkoxy groups having 1 to 7 carbon atoms, an acetyl group or a nitro group. Preferable examples of the aryl group represented by Y₃ to Y₅ include phenyl and naphthyl. As a preferable substituent present on the aryl group, alkyl and alkoxy groups having 1 to 7 carbon atoms, halogen atoms, a nitro group, a cyano group, and dialkylamino groups having 1 to 7 carbon atoms such as dimethylamino and diethylamino can be referred to. Preferable examples of the aralkyl group include phenylalkyl groups having 7 to 10 carbon atoms. As preferable examples of the substituent present on their phenyl moiety, lower alkyl groups, lower alkoxy groups, halogen atom, a nitro group, a cyano group, a dimethylamino group and a diethylamino group can be referred to. Preferable examples of the optionally substituted alkyl group represented by Y₆ to Y₉ include straight chain and branched chain alkyl groups having 1 to 6 carbon atoms, among which methyl, ethyl, n-propyl and n-butyl are more preferable. Preferable examples of the optionally substituted aryl group represented by Y₆ to Y₉ include a phenyl group and naphthyl group, among which the phenyl group is more preferable.

The compounds represented by the formula (IV) can be produced by, for example, reacting the corresponding nitrile compound with aluminum bromide in the presence of hydrogen chloride or by using the corresponding imidate compound, according to Bull. Chem. Soc. Japan, 42, 2924 (1969); US-A- 3,987,037; or F. C. Schaefer et. al, J. Org. Chem. 29, 1527 (1964).

Examples of the compound represented by the formula (IV) include the compound disclosed in the papers mentioned above, the compound disclosed in GB-B- 1,388,492 and Japanese Patent Application JP-A-53-133428 (1978)and the compound having the following formula: 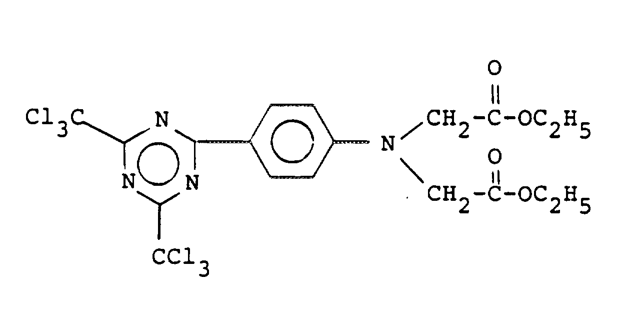 disclosed in JP-A-63-153542 (1988) and the like. Among these compounds, preferable are 2,4,6-tris(trichloromethyl)-s-triazine, 2-phenyl-4,6-bis(trichloromethyl)-s-triazine, 2,4,6-tris(dibromopropyl)-s-triazine, 2-(p-acetylphenyl)-4,6-bis(trichloromethyl)-s-triazine, 2-(p-chlorophenyl)-4,6-bis(trichloromethyl)-s-triazine and 2-(p-methoxyphenyl)-4,6-bis(trichloromethyl)-s-triazine.

Examples of the trifluoromethanesulfonic acid ester include compounds represented by the following formula (V):

CF₃SO₂O-(CH₂)ₙ-Y₁₀ (V)

wherein Y₁₀ represents an optionally substituted aryl group and n represents 0 or 1; compounds represented by the following formula (VI): 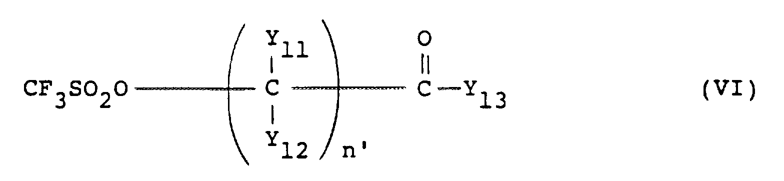 wherein Y₁₁ and Y₁₂ independently of one another each represents a hydrogen atom or an optionally substituted alkyl, alkoxy or aryl group, Y₁₃ represents an optionally substituted aryl group and n' represents 1 or 2; compounds represented by the following formula (VII): 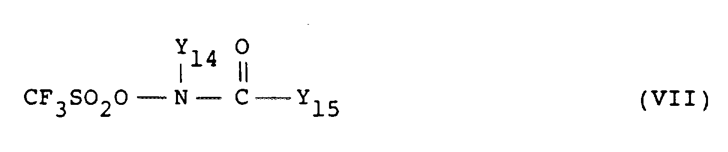 wherein Y₁₄ represents an optionally substituted alkyl group and Y₁₅ represents an optionally substituted aryl group, and compounds represented by the following formula (VIII):

CF₃SO₂O-N=C(Y₁₆)(Y₁₇) (VIII)

wherein Y₁₆ represents a hydrogen atom or an optionally substituted alkyl or aryl group and Y₁₇ represents an optionally substituted aryl group.

The compounds represented by the above-mentioned formulas (V) and (VI) can be produced by reacting the corresponding alcohol or phenol with trifluoromethanesulfonyl chloride or the like in the presence of a base such as pyridine. The compounds represented by the formula (VII) can be produced by brominating the corresponding acid amide in the presence of an alkali and then reacting the resulting bromide with sodium trifluoromethanesulfonate or the like under a weakly acidic condition. The compounds represented by the formula (VIII) can be produced by reacting the corresponding carbonyl compound with hydroxylamine and then reacting the resulting oxime with trifluoromethanesulfonic acid anhydride at a low temperature. Preferable examples of the trifluoromethanesulfonic acid ester include the following:

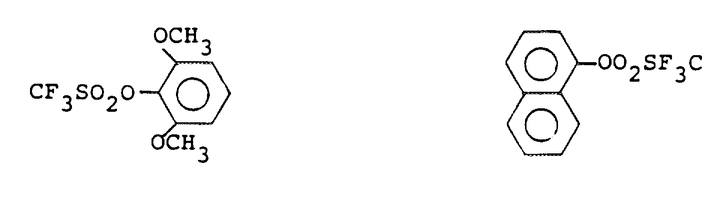

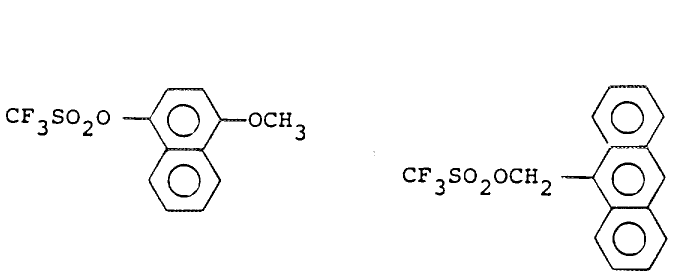

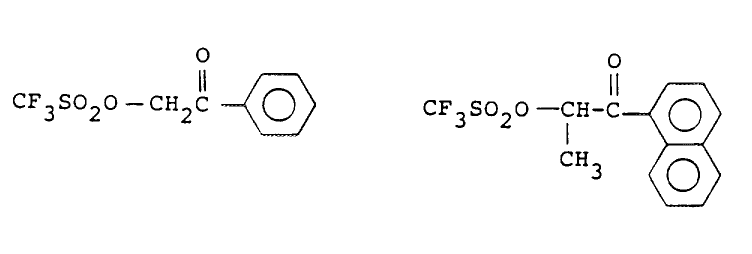

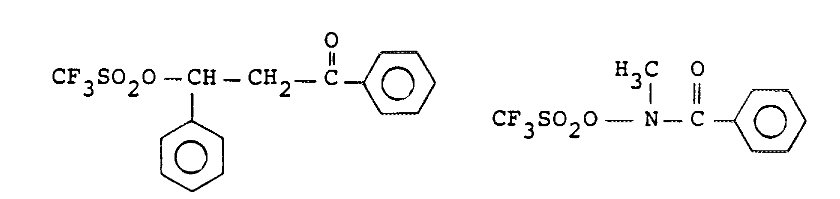

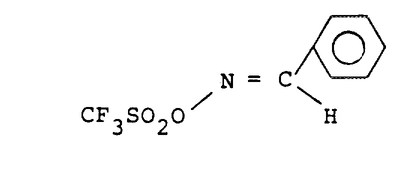

In the formulas (IX) and (X), preferable examples of the aryl group represented by Y₁₈, Y₁₉, Y₂₀ and Y₂₂ include phenyl, 1-naphthyl and 2-naphthyl. Preferable examples of the aralkyl group represented by Y₁₈, Y₁₉, Y₂₀ and Y₂₂ include benzyl, phenethyl, naphthylmethyl and naphthylethyl. As the substituents present on these groups, a nitro group, halogen atoms, a lower alkyl, alkenyl or alkoxy group, a bis(lower alkyl)-amino group, a (lower alkyl)-carbonylamino group and an arylcarbonylamino group can be referred to. Preferable examples of the alkyl group represented by Y₁₈, Y₁₉, Y₂₀ and Y₂₂ include straight chain and branched chain alkyl groups having 1 to 8 carbon atoms. Preferable examples of the cycloalkyl group represented by Y₁₈, Y₁₉, Y₂₀ and Y₂₂ include cycloalkyl groups having 5 to 8 carbon atoms. As the substituents present on these groups, halogen atoms can be referred to. Preferable examples of the heterocyclic group include monocyclic and bicyclic heterocyclic groups exhibiting an aromatic character such as a quinolyl group.

Preferable examples of the aryl group represented by Y₂₁ include phenyl, biphenyl, 1-naphthyl and 2-naphthyl. As the substituent present on these groups, a nitro group, halogen atoms, a lower alkyl group and a lower alkoxy group can be referred to. The disulfone compounds represented by the formula (IX) and the compounds represented by the formula (X) can be produced according to the methods mentioned in, for example, JP-A-1-284554 (1989);

Journal of Organic Chemistry, 31, 3418-3419 (1966); Journal of the Chemical Society, 93, 1524-1527 (1908); Berichte der Deutschen Chemischen Gesellschaft, 49, 2593-2594 (1916); etc., namely according to a method which comprises producing the compounds of these formulas from sulfinic acid by the use of cobalt (III) sulfate in an aqueous solution of sulfuric acid, a method which comprises producing the compounds from sulfonyl chloride by the use of ethyl xanthogenate, a method which comprises producing the compounds by reacting sulfinic acid and sulfonyl chloride under a basic condition, a method which comprises reacting hydrazine with sulfonyl chloride to form 1,2-disulfonylhydrazine and then oxidizing the latter with concentrated nitric acid, and the like.

Among the disulfone compounds represented by the formula (IX) and the compounds represented by the formula (X), preferable are, for example, the following:

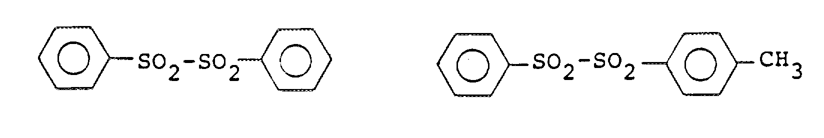

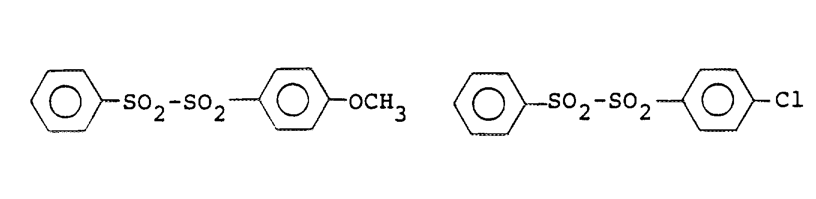

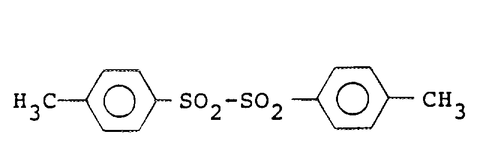

As other photo-induced acid precursor, the onium salts represented by the following formulas can be referred to, for example:

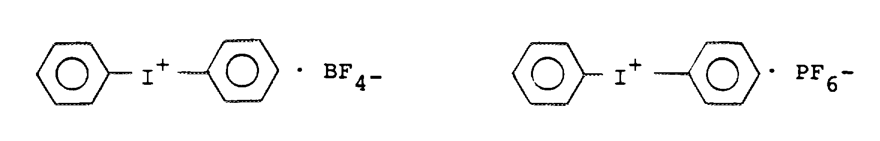

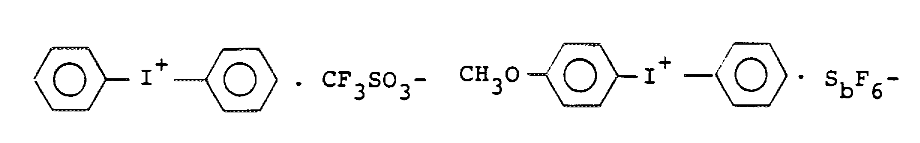

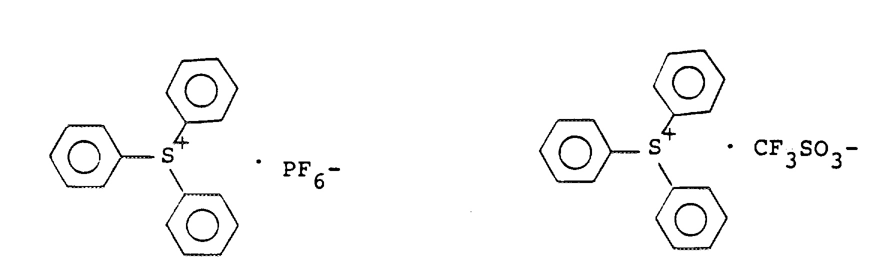

The photo-induced acid precursor are used either singly or in the form of a mixture of two or more members.

In the negative photoresist composition of the present invention, the alkali-soluble resin is used usually in an amount of from 20 to 90% by weight (preferably in an amount of from 40 to 80% by weight), the crosslinking agent is used usually in an amount of from 5 to 50% by weight (preferably in an amount of from 5 to 20% by weight), the photo-induced acid precursor is used usually in an amount of from 0.1 to 20% by weight (preferably in an amount of from 1 to 20% by weight), respectively. If necessary, the negative photoresist composition of the present invention may contain a sensitizer, a dye and the like.

Generally speaking, a negative resist solution is prepared by mixing an alkali-soluble resin, a cross-linking agent, a photo-induced acid precursor and the like into a solvent. These ingredients are used in an amount of from 1 to 50% by weight of the resulting negative resist solution. The solvent is preferably one that evaporates at an appropriate drying rate to give a uniform and smooth coating film. Examples of such solvent include methyl cellosolve acetate, ethyl cellosolve acetate, methyl cellosolve, ethyl cellosolve, propylene glycol monomethyl ether acetate, propylene glycol monoethyl ether acetate, butyl acetate, methyl isobutyl ketone, xylene, ethyl lactate, ethyl pyruvate and 2-heptanone. These solvents are used either singly or in the form of a mixture of two or more members.

Next, the present invention will be explained by the following examples.

In examples, "parts" are by weight.

### Example 1

Fifty parts of diethylene glycol dimethyl ether were mixed with 9.33 parts of Resin A [LYNCUR CST-70, manufactured by Maruzen Sekiyukagaku K. K., weight average molecular weight 2,900, p-hydroxystyrene/styrene molar ratio in copolymer 70/30], 4 parts of Resin B [MARUKA LYNCUR-C, manufactured by Maruzen Sekiyukagaku K. K., weight average molecular weight 5,200], 1 part of hexamethylolmelamine hexamethyl ether and 3 parts of tris(2,3-dibromopropyl)-1,3,5-triazine (a reagent manufactured by Tokyo Kasei Kogyo K. K.] as a photo-induced acid precursor. The resulting mixture was filtered through a tetrafluoroethylene filter having a pore size of 0.2 µm to obtain a resist solution. Using a spinner, the resist solution was coated on a silicon wafer which had been rinsed in a usual manner to form a resist film of 0.7 µm in thickness. Subsequently, the silicon wafer was pre-baked in an oven at 100°C for one minute, and the coated film on the wafer was exposed to light by means of KrF Excimer Laser Stepper (manufactured by Nikon Co., NSR1755EX NA=0.45) having an exposure wavelength of 248 nm. After the exposure, the wafer was heated on a hot plate at 100°C for one minute to make progress a crosslinking reaction of the exposed area. Then, the wafer was developed with 2.0% (by weight) aqueous solution of tetramethylammonium hydroxide to obtain a negative pattern. An observation by means of an electron microscope revealed that a 0.25 µm fine pattern was resolved with a good profile, provided that exposure dose was 40 mJ/cm (effective sensitivity).

### Example 2

A negative pattern was obtained by repeating Example 1, except that the photo-induced acid precursor was altered to diphenyl disulfone. A 0.25 µm fine pattern was resolved with a good profile, provided that exposure dose was 20 mJ/cm (effective sensitivity).

### Example 3

A negative pattern was obtained by repeating Example 1, except that, after the exposure to light, the wafer was heated on a hot plate at 120°C. A 0.25 µm fine pattern was resolved with a good profile, provided that exposure dose was 15 mJ/cm (effective sensitivity).

### Example 4

A negative pattern was obtained by repeating Example 1, except that Resin A was altered to LYNCUR CST-50 (manufactured by Maruzen Sekiyukagaku K. K., weight average molecular weight 3,600, p-hydroxystyrene/styrene ratio in copolymer 50/50). A 0.25 µm fine pattern was resolved with a good profile, provided that exposure dose was 60 mJ/cm (effective sensitivity).

### Comparative Example 1

The procedure of Example 1 was repeated, except that the mixture of Resin A and Resin B was replaced with 13.33 parts of poly(p-hydroxystyrene) (MARUKA LYNCUR M, manufactured by Maruzen Sekiyukagaku K. K., weight average molecular weight 4,100). As a result, a sensitivity of 35 mJ/cm was obtained. However, a 0.25 µm pattern could not be resolved.

## Claims

1. A negative photoresist composition comprising an alkali-soluble resin containing a mixture of Resin A obtainable through a copolymerization of p-hydroxystyrene and styrene and Resin B obtainable through a hydrogenation of poly(p-hydroxystyrene), a crosslinking agent and a photo-induced acid precursor.

2. A negative photoresist composition according to Claim 1, wherein the crosslinking agent is a compound represented by the following general formula (II): 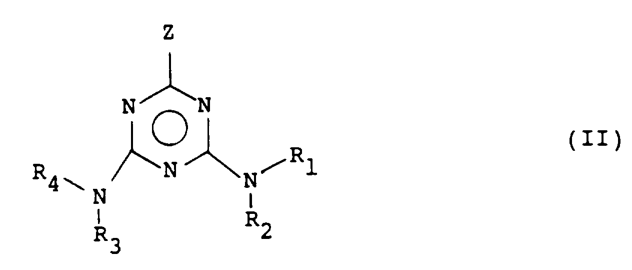 wherein Z represents -NRR' or a phenyl group; and R, R', R₁, R₂, R₃ and R₄ independently of one another each represents a hydrogen atom, -CH₂OH or -CH₂ORₐ in which Rₐ is an alkyl group.

3. A negative photoresist composition according to Claim 1 or 2, wherein the photo-induced acid precursor is a compound represented by the following general formula (III): 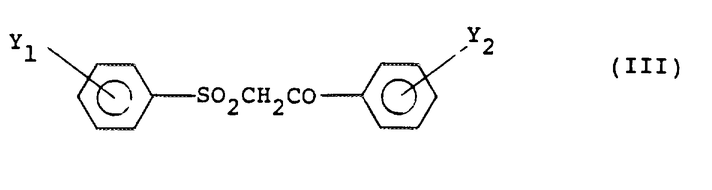 wherein Y₁ and Y₂ independently of one another each represents a hydrogen atom, an alkyl group, an alkenyl group or an alkoxy group.

4. A negative photoresist composition according to Claim 1 or 2, wherein said photo-induced acid precursor is a compound represented by the following general formula (IV): 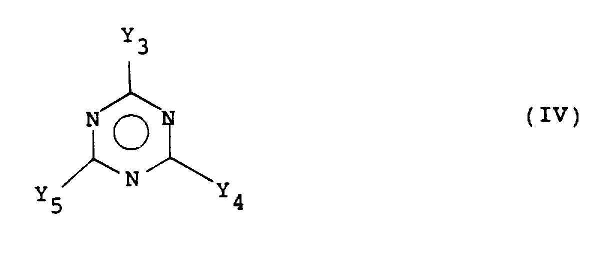 wherein Y₃, Y₄ and Y₅ each represents optionally substituted alkyl, alkenyl, aryl, aralkyl or piperidino group, -N(Y₆)(Y₇), -OY₈ or -SY₉, provided that at least one of Y₃, Y₄ and Y₅ represents a mono-, di- or tri-halogen-substituted alkyl group; and Y₆, Y₇, Y₈ and Y₉ independently of one another each represents a hydrogen atom or an optionally substituted alkyl or aryl group.

5. A negative photoresist composition according to Claim 1 or 2, wherein the photo-induced acid precursor is a trifluoromethanesulfonic acid ester.

6. A negative photoresist composition according to Claim 5, wherein said trifluoromethanesulfonic acid ester is a compound represented by the following general formula (V):
CF₃SO₂O-(CH₂)ₙ-Y₁₀ (V)
wherein Y₁₀ represents an optionally substituted aryl group and n represents 0 or 1.

7. A negative photoresist composition according to Claim 5, wherein the trifluoromethanesulfonic acid ester is a compound represented by the following general formula (VI): 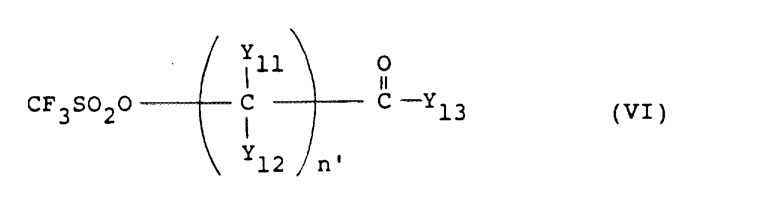 wherein Y₁₁ and Y₁₂ independently of one another each represents a hydrogen atom or an optionally substituted alkyl, alkoxy or aryl group; Y₁₃ represents an optionally substituted aryl group; and n' represents 1 or 2.

8. A negative photoresist composition according to Claim 5, wherein the trifluoromethanesulfonic acid ester is a compound represented by the following general formula (VII): 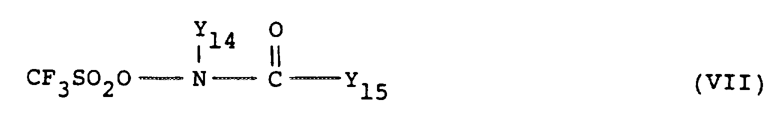 wherein Y₁₄ represents an optionally substituted alkyl group and Y₁₅ represents an optionally substituted aryl group.

9. A negative photoresist composition according to Claim 5, wherein said trifluoromethanesulfonic acid ester is a compound represented by the following general formula (VIII):
CF₃SO₂O-N=C(Y₁₆)(Y₁₇) (VIII)
wherein Y₁₆ represents a hydrogen atom or an optionally substituted alkyl or aryl group and Y₁₇ represents an optionally substituted aryl group.

10. A negative photoresist composition according to Claim 1 or 2, wherein the photo-induced acid precursor is a disulfone compound represented by the following general formula (IX):
Y₁₈-SO₂-SO₂-Y₁₉ (IX)
wherein Y₁₈ and Y₁₉ each represent an optionally substituted aryl, aralkyl, alkyl, cycloalkyl or heterocyclic group, provided that at least one of Y₁₈ and Y₁₉ is an optionally substituted aryl, aralkyl or heterocyclic group.

11. A negative photoresist composition according to Claim 1 or 2, wherein the photo-induced acid precursor is a compound represented by the following general formula:
Y₂₀-SO₂-SO₂-Y₂₁-SO₂-SO₂-Y₂₂ (X)
wherein Y₂₀ and Y₂₂ independently of one another each represents an optionally substituted aryl, aralkyl, alkyl, cycloalkyl or heterocyclic group and Y₂₁ represents an optionally substituted aryl group.

## Patentansprüche

1. Negative Photoresistzusammensetzung, umfassend ein basenlösliches Harz, das ein Gemisch aus Harz A, das durch Copolymerisation von p-Hydroxystyrol und Styrol erhältlich ist, und Harz B, das durch Hydrieren von Poly(p-hydroxystyrol) erhältlich ist, ein Vernetzungsmittel und eine photoinduzierte Säurevorstufe enthält.

2. Negative Photoresistzusammensetzung nach Anspruch 1, in der das Vernetzungsmittel eine durch folgende allgemeine Formel (II) wiedergegebene Verbindung ist: 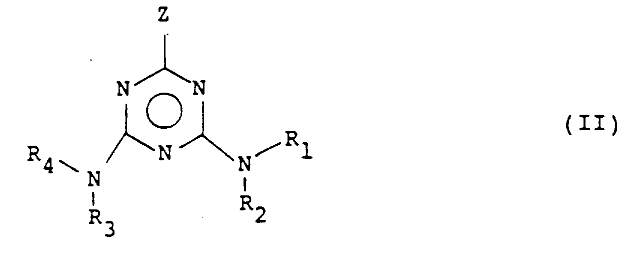 in der Z -NRR' oder eine Phenylgruppe darstellt, und R, R', R₁, R₂, R₃ und R₄ unabhängig voneinander jeweils ein Wasserstoffatom, -CH₂OH oder -CH₂ORₐ darstellen, wobei Rₐ ein Alkylrest ist.

3. Negative Photoresistzusammensetzung nach Anspruch 1 oder 2, in der die photoinduzierte Säurevorstufe eine durch folgende allgemeine Formel (III) wiedergegebene Verbindung ist: 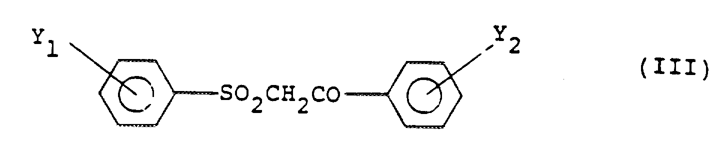 in der Y₁ und Y₂ unabhängig voneinander jeweils ein Wasserstoffatom, einen Alkyl-, Alkenyl- oder Alkoxyrest darstellen.

4. Negative Photoresistzusammensetzung nach Anspruch 1 oder 2, in der die photoinduzierte Säurevorstufe eine durch folgende allgemeine Formel (IV) wiedergegebene Verbindung ist: 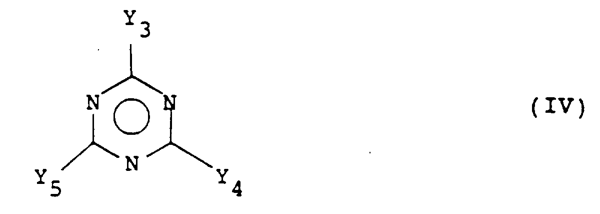 in der Y₃, Y₄ und Y₅ jeweils eine gegebenenfalls substituierte Alkyl-, Alkenyl-, Aryl-, Aralkyl- oder Piperidinogruppe, -N(Y₆)(Y₇), -OY₈ oder -SY₉ darstellen, mit der Maßgabe, daß mindestens einer der Reste Y₃, Y₄ und Y₅ einen mono-, di- oder trihalogensubstituierten Alkylrest darstellt, und Y₆, Y₇, Y₈ und Y₉ unabhängig voneinander jeweils ein Wasserstoffatom oder einen gegebenenfalls substituierten Alkyl- oder Arylrest darstellen.

5. Negative Photoresistzusammensetzung nach Anspruch 1 oder 2, in der die photoinduzierte Säurevorstufe ein Trifluormethansulfonsäureester ist.

6. Negative Photoresistzusammensetzung nach Anspruch 5, in der der Trifluormethansulfonsäureester eine durch folgende allgemeine Formel (V) wiedergegebene Verbindung ist:
CF₃SO₂O-(CH₂)ₙ-Y₁₀ (V)
in der Y₁₀ einen gegebenenfalls substituierten Arylrest darstellt und n 0 oder 1 ist.

7. Negative Photoresistzusammensetzung nach Anspruch 5, in der der Trifluormethansulfonsäureester eine durch folgende allgemeine Formel (VI) wiedergegebene Verbindung ist: 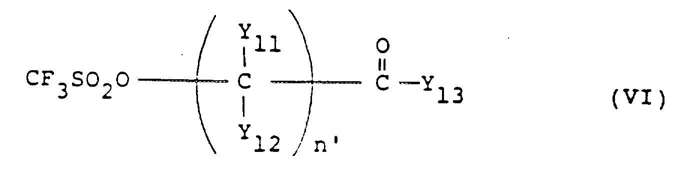 in der Y₁₁ und Y₁₂ unabhängig voneinander jeweils ein Wasserstoffatom oder einen gegebenenfalls substituierten Alkyl-, Alkoxy- oder Arylrest darstellen, Y₁₃ einen gegebenenfalls substituierten Arylrest darstellt und n' 1 oder 2 ist.

8. Negative Photoresistzusammensetzung nach Anspruch 5, in der der Trifluormethansulfonsäureester eine durch folgende allgemeine Formel (VII) wiedergegebene Verbindung ist: 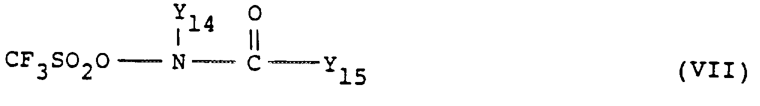 in der Y₁₄ einen gegebenenfalls substituierten Alkylrest darstellt und Y₁₅ einen gegebenenfalls substituierten Arylrest darstellt.

9. Negative Photoresistzusammensetzung nach Anspruch 5, in der der Trifluormethansulfonsäureester eine durch folgende allgemeine Formel (VIII) wiedergegebene Verbindung ist:
CF₃SO₂O-N=C(Y₁₆)(Y₁₇) (VIII)
in der Y₁₆ ein Wasserstoffatom oder einen gegebenenfalls substituierten Alkyl - oder Arylrest darstellt und Y₁₇ einen gegebenenfalls substituierten Arylrest darstellt.

10. Negative Photoresistzusammensetzung nach Anspruch 1 oder 2, in der die photoinduzierte Säurevorstufe eine durch folgende allgemeine Formel (IX) wiedergegebene Disulfonverbindung ist:
Y₁₈-SO₂-SO₂-Y₁₉ (IX)
in der Y₁₈ und Y₁₉ jeweils einen gegebenenfalls substituierten Aryl-, Aralkyl-, Alkyl-, Cycloalkyl- oder heterocyclischen Rest darstellen, mit der Maßgabe, daß mindestens einer der Reste Y₁₈ und Y₁₉ ein gegebenenfalls substituierter Aryl-, Aralkyl- oder heterocyclischer Rest ist.

11. Negative Photoresistzusammensetzung nach Anspruch 1 oder 2, in der die photoinduzierte Säurevorstufe eine durch folgende allgemeine Formel wiedergegebene Verbindung ist:
Y₂₀-SO₂-SO₂-Y₂₁-SO₂-SO₂-Y₂₂ (X)
in der Y₂₀ und Y₂₂ unabhängig voneinander jeweils einen gegebenenfalls substituierten Aryl-, Aralkyl-, Alkyl-, Cycloalkyl- oder heterocyclischen Rest darstellen und Y₂₁ einen gegebenenfalls substituierten Arylrest darstellt.

## Revendications

1. Composition d'agent de réserve à photorésistance négative, comprenant une résine soluble en liquide alcalin qui contient un mélange de résine A pouvant être obtenue par copolymérisation de p-hydroxystyrène et de styrène et de résine B qui peut être obtenue par hydrogénation de poly(p-hydroxystyrène), un réticulant et un précurseur d'acide à photoinduction.

2. Composition d'agent de réserve à photorésistance négative selon la revendication 1, dans laquelle le réticulant est un composé représenté par la formule générale (II) suivante: 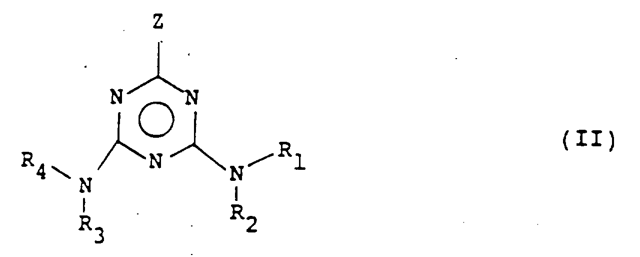 dans laquelle Z représente -NRR' ou un groupement phényle; et R, R', R₁, R₂, R₃ et R₄ représentent chacun, indépendamment les uns des autres, un atome d'hydrogène, -CH₂OH ou -CH₂ORₐ, Rₐ étant un groupement alkyle.

3. Composition d'agent de réserve à photorésistance négative selon la revendication 1 ou 2, dans laquelle le précurseur d'acide à photoinduction est un composé représenté par la formule générale (III) suivante: 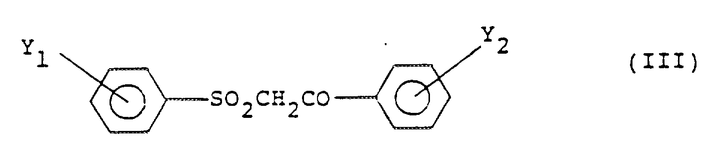 dans laquelle Y₁ et Y₂ représentent chacun, indépendamment l'un de l'autre, un atome d'hydrogène, un groupement alkyle, un groupement alcényle ou un groupement alcoxy,

4. Composition d'agent de réserve à photorésistance négative selon la revendication 1 ou 2, dans laquelle ledit précurseur d'acide à photoinduction est un composé représenté par la formule générale (IV) suivante: 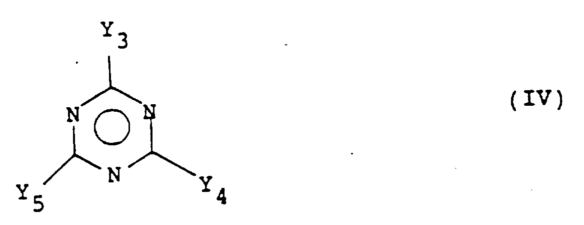 dans laquelle Y₃, Y₄ et Y₅ représentent chacun un groupement alkyle, alcényle, aryle, aralkyle ou pipéridino éventuellement substitués, -N(Y₆)(Y₇), -OY₈ ou -SY₉, étant spécifié que l'un au moins de Y₃, Y₄ et Y₅ représente un groupement alkyle mono-, di- ou tri-halogénosubstitué; et Y₆, Y₇, Y₈ et Y₉ représentent chacun, indépendamment les uns des autres, un atome d'hydrogène ou un groupement alkyle ou aryle éventuellement substitués.

5. Composition d'agent de réserve à photorésistance négative selon la revendication 1 ou 2, dans laquelle le précurseur d'acide à photoinduction est un ester d'acide trifluorométhanesulfonique.

6. Composition d'agent de réserve à photorésistance négative selon la revendication 5, dans laquelle ledit ester d'acide trifluorométhanesulfonique est un composé représenté par la formule générale (V) suivante:
CF₃SO₂O-(CH₂)ₙ-Y₁₀ (V)
dans laquelle Y₁₀ représente un groupement aryle éventuellement substitué et n représente 0 ou 1.

7. Composition d'agent de réserve à photorésistance négative selon la revendication 5, dans laquelle l'ester d'acide trifluorométhanesulfonique est un composé représenté par la formule générale (VI) suivante: 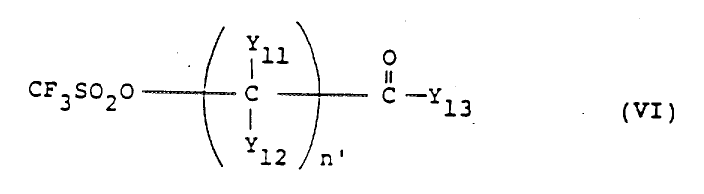 dans laquelle Y₁₁ et Y₁₂ représentent chacun, indépendamment l'un de l'autre, un atome d'hydrogène ou un groupement alkyle, alcoxy ou aryle éventuellement substitués; Y₁₃ représente un groupement aryle éventuellement substitué; et n' représente 1 ou 2.

8. Composition d'agent de réserve à photorésistance négative selon la revendication 5, dans laquelle l'ester d'acide trifluorométhanesulfonique est un composé représenté par la formule générale (VII) suivante: 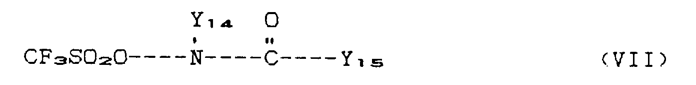 dans laquelle Y₁₄ représente un groupement alkyle éventuellement substitué et Y₁₅ représente un groupement aryle éventuellement substitué.

9. Composition d'agent de réserve à photorésistance négative selon la revendication 5, dans laquelle ledit ester d'acide trifluorométhanesulfonique est un composé représenté par la formule générale (VIII) suivante:
CF₃SO₂O-N=C(Y₁₆)(Y₁₇) (VIII)
dans laquelle Y₁₆ représente un atome d'hydrogène ou un groupement alkyle ou aryle éventuellement substitué et Y₁₇ représente un groupement aryle éventuellement substitué.

10. Composition d'agent de réserve à photorésistance négative selon la revendication 1 ou 2, dans laquelle le précurseur d'acide à photoinduction est une disulfone représentée par la formule générale (IX) suivante:
Y₁₈-SO₂-SO₂-Y₁₉ (IX)
dans laquelle Y₁₈ et Y₁₉ représentent chacun un groupement aryle, aralkyle, alkyle, cycloalkyle ou hétérocyclique éventuellement substitués, étant spécifié que l'un au moins de Y₁₈ et Y₁₉ est un groupement aryle, aralkyle ou hétérocyclique éventuellement substitués.

11. Composition d'agent de réserve à photorésistance négative selon la revendication 1 ou 2, dans laquelle le précurseur d'acide à photoinduction est un composé représenté par la formule générale suivante:
Y₂₀-SO₂-SO₂-Y₂₁-SO₂-SO₂-Y₂₂ (X)
dans laquelle Y₂₀ et Y₂₂ représentent chacun, indépendamment l'un de l'autre, un groupement aryle, aralkyle, alkyle, cycloalkyle ou hétérocyclique éventuellement substitués et Y₂₁ représente un groupement aryle éventuellement substitué.
